# DEMANDE DE BREVET EUROPEEN

(11) **EP 2 166 570 A1**
(43) Date de publication de la demande: **24.03.2010**
(21) Numéro de dépôt: 09169842.3
(22) Date de dépôt: 09.09.2009
(51) Int. Cl.: H01L 23/498

(54) **Procédé d'encapsulation d'un composant électronique à semi-conducteur**

(30) Priorité: 12.09.2008 FR 0856159
(71) Demandeur: ALSTOM Transport SA, 92300 Levallois-Perret (FR)
(72) Inventeur: Lasserre, Philippe, 64320, Ousse (FR); Lebey, Thierry, 31120, Lacroix Falgarde (FR); Duchesne, Cyrille, 65000, Terbes (FR)
(74) Mandataire: Blot, Philippe Robert Emile

(57) **Abrégé**

L'invention concerne un procédé d'encapsulation d'un composant électronique à semi-conducteur comportant des pistes conductrices (5-7) déposées en relief sur une surface d'une plaquette (2) en céramique isolante, lesdites pistes conductrices comprenant des bords latéraux (8) de sorte que lesdits bords latéraux forment avec la surface de ladite plaquette respectivement les bords et le fond de tranchées (9) séparant les pistes conductrices.

Ce procédé comprend une étape consistant à déposer dans ladite tranchée un matériau hybride (11) comprenant un liant isolant comportant des particules en matériau semi-conducteur en suspension.

## Description

La présente invention concerne un procédé d'encapsulation d'un composant électronique à semi-conducteur, et plus particulièrement d'un tel composant comportant des pistes conductrices déposées en relief sur une surface d'une plaquette en céramique isolante, lesdites pistes conductrices comprenant des bords latéraux de sorte que lesdits bords latéraux forment avec la surface de ladite plaquette respectivement les bords et le fond de tranchées séparant les pistes conductrices,

L'utilisation d'une électronique de puissance intégrée permet des gains concernant la masse des systèmes embarqués et augmente la fiabilité des systèmes. Cependant, l'inévitable montée en tension des semi-conducteurs de puissance conduit à s'interroger sur la fiabilité de leur environnement. Si les connaissances accumulées sur les mécanismes de défaillances des semi-conducteurs ont permis de développer des règles de dimensionnement qui leur permettent de fonctionner de manière fiable, il n'en est pas de même pour leur environnement, c'est-à-dire pour l'ensemble du sous système et matériaux composant l'isolation du boîtier. En effet, celui-ci supporte des contraintes électriques pour lesquelles il n'a pas forcément été dimensionné, et les matériaux isolants constituent généralement dans le boîtier un point faible de l'isolation.

Une solution élémentaire consiste à surdimensionner l'ensemble de ces matériaux pour garantir la tenue en tension. Mais il en résulte une augmentation de la densité de puissance à dimension constante, de sorte que le surdimensionnement des isolants a une limite. Il faut toutefois être capable de faire fonctionner ces dispositifs intégrés aux niveaux des tensions envisagés.

La présente invention vise à palier ces inconvénients.

A cet effet, l'invention a tout d'abord pour objet un procédé d'encapsulation d'un composant électronique à semi-conducteur comportant des pistes conductrices déposées en relief sur une surface d'une plaquette en céramique isolante, lesdites pistes conductrices comprenant des bords latéraux de sorte que lesdits bords latéraux forment avec la surface de ladite plaquette respectivement les bords et le fond de tranchées séparant les pistes conductrices, ledit procédé comprenant une étape consistant à déposer dans ladite tranchée un matériau hybride comprenant un liant isolant comportant des particules en matériau semi-conducteur en suspension.

Dans un mode de mise en oeuvre particulier, ledit liant isolant est choisi dans le groupe comprenant les gels, les vernis, les colles et les résines.

Egalement dans un mode de mise en oeuvre particulier, le matériau semi-conducteur desdites particules est choisi dans le groupe comprenant l'oxyde de zinc, le carbure de silicium et le graphite, ou un mélange de ces matériaux.

Plus particulièrement, le matériau hybride peut comprendre au moins 18%, notamment entre 40% et 60%, en masse de particules en matériau semi-conducteur.

Egalement dans un mode de réalisation particulier, le procédé selon l'invention peut comporter une étape consistant à déposer une couche de matériau isolant par-dessus les pistes conductrices et le matériau hybride.

Plus particulièrement, ledit matériau isolant peut être un gel de silicone.

L'invention a également pour objet un composant électronique à semi-conducteur comportant des pistes conductrices déposées en relief sur une surface d'une plaquette en céramique isolante, lesdites pistes conductrices comprenant des bords latéraux de sorte que lesdits bords latéraux forment avec la surface de ladite plaquette respectivement les bords et le fond de tranchées séparant les pistes conductrices, ledit composant étant encapsulé de la manière décrite ci-dessus.

L'invention a également pour objet un équipement électronique de puissance comprenant au moins un tel composant électronique à semi-conducteur.

On décrira maintenant, à titre d'exemple non limitatif, un mode de réalisation particulier de l'invention, en référence aux dessins schématiques annexés dans lesquels :
- la figure 1 est une vue en perspective d'un composant électronique à semi-conducteur selon l'invention ; et
- la figure 2 est une vue en coupe partielle de ce composant.

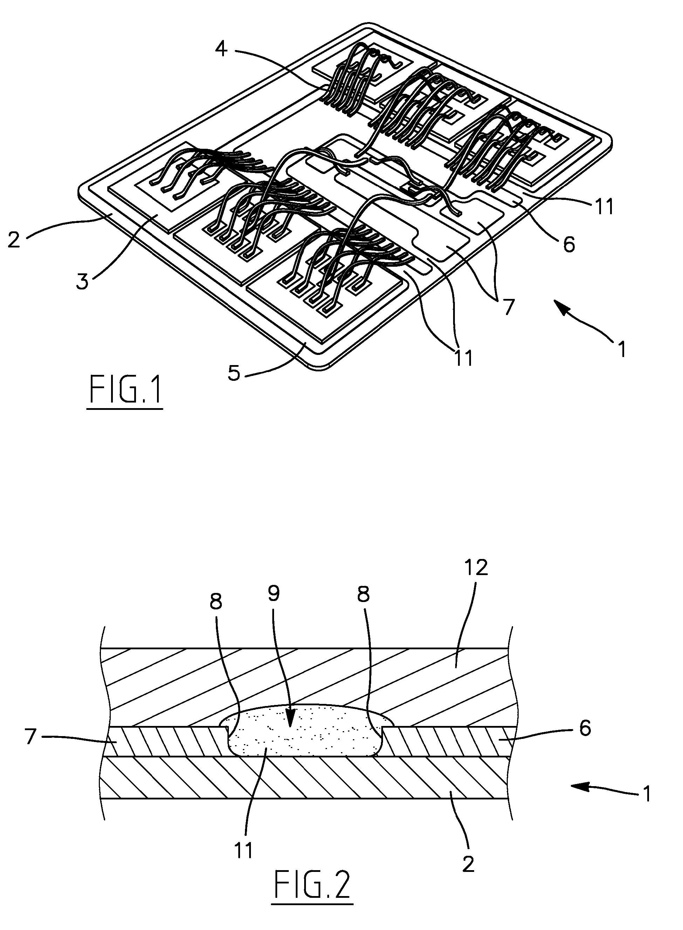

Le composant 1 des figures 1 et 2 comprend une plaquette 2 en céramique isolante sur laquelle des puces 3 à semi-conducteur, ici par exemple des diodes et des transistors IGBT, sont disposées de façon connue. Egalement de façon connue, les puces 3 sont reliées par des fils conducteurs 4 à des pistes conductrices en cuivre déposées sur la plaquette 2, ici une piste collectrice 5, une piste émettrice 6 de report de puissance, et une piste 7 de commande des puces IGBT.

Les pistes comportent des bords latéraux 8 qui délimitent des tranchées 9 dont le fond est constitué par la surface de la plaquette en céramique 2.

Dans l'état de la technique, les composants tels que celui qui a été décrit jusqu'à présent sont ensuite encapsulés dans un gel silicone isolant. Il en résulte de fortes contraintes électriques notamment aux l'interfaces cuivre/gel silicone et cuivre/céramique.

Selon l'invention, on dépose une couche 11 d'un matériau hybride comprenant un liant isolant comportant des particules en matériau semi-conducteur en suspension, tout le long des tranchées séparant les pistes conductrices. Le reste de l'encapsulation est effectué avec le gel isolant de l'état de la technique. A titre d'exemple, la couche de matériau hybride peut avoir une épaisseur comprise entre 200 µm et 500 µm pour une épaisseur de piste de l'ordre de 300 µm.

Le liant isolant du matériau hybride peut être un gel, par exemple un gel silicone du type de ceux généralement utilisés comme matériau isolant d'encapsulation, une colle adhésive, un vernis ou une résine, par exemple une résine phénolique ou une résine alkyde.

Les particules semi-conductrices en suspension peuvent être par exemple de l'oxyde de zinc, du carbure de silicium ou du graphite, ou un mélange de ces matériaux. Il a été constaté que le matériau semi-conducteur doit former au moins 18% de la masse totale du matériau hybride, par exemple entre 40% et 60%.

Le matériau hybride permet l'étirement des lignes de potentiel, symbolisant les renforcements de champ électrique, entre les pistes conductrices en cuivre. Le liant doit avoir une forte tenue diélectrique pour garantir la tenue en tension entre les pistes. Les particules semi-conductrices permettent alors une gradation du champ électrique de par leurs propriétés intrinsèques. Ainsi une variation du taux de particules insérées dans la base choisie pour l'isolation diélectrique permet une gradation plus ou moins importante de la contrainte électrique.

Le choix du taux et de la nature des particules semi-conductrices dans le matériau hybride permet une variation de l'effet gradateur du matériau. La diminution de la contrainte aux abords des pistes conductrices permet une augmentation du seuil d'apparition des décharges partielles, responsables de la rupture des matériaux isolants. On amélioration le vieillissement de la céramique servant d'isolant au substrat.

## Revendications

1. Procédé d'encapsulation d'un composant électronique à semi-conducteur comportant des pistes conductrices déposées en relief sur une surface d'une plaquette en céramique isolante, lesdites pistes conductrices comprenant des bords latéraux de sorte que lesdits bords latéraux forment avec la surface de ladite plaquette respectivement les bords et le fond de tranchées séparant les pistes conductrices, **caractérisé par le fait qu'**il comprend une étape consistant à déposer dans ladite tranchée un matériau hybride comprenant un liant isolant comportant des particules en matériau semi-conducteur en suspension.

2. Procédé selon la revendication 1, dans lequel ledit liant isolant est choisi dans le groupe comprenant les gels, les vernis, les colles et les résines.

3. Procédé selon l'une quelconque des revendications 1 et 2, dans lequel le matériau semi-conducteur desdites particules est choisi dans le groupe comprenant l'oxyde de zinc, le carbure de silicium et le graphite, ou un mélange de ces matériaux.

4. Procédé selon l'une quelconque des revendications 1 à 3, dans lequel le matériau hybride comprend au moins 18% en masse de particules en matériau semi-conducteur.

5. Procédé selon la revendication 4, dans lequel le matériau hybride comprend entre 40% et 60% en masse de particules en matériau semi-conducteur.

6. Procédé selon l'une quelconque des revendications 1 à 5, comportant une étape consistant à déposer une couche de matériau isolant par-dessus les pistes conductrices et le matériau hybride.

7. Procédé selon la revendication 6, dans lequel ledit matériau isolant est un gel de silicone.

8. Composant électronique à semi-conducteur comportant des pistes conductrices déposées en relief sur une surface d'une plaquette en céramique isolante, lesdites pistes conductrices comprenant des bords latéraux de sorte que lesdits bords latéraux forment avec la surface de ladite plaquette respectivement les bords et le fond de tranchées séparant les pistes conductrices, **caractérisé par le fait qu'**il est encapsulé par un procédé selon l'une quelconque des revendications 1 à 7.

9. Equipement électronique de puissance, **caractérisé par le fait qu'**il comprend au moins un composant électronique à semi-conducteur selon la revendication 8.
